# EUROPEAN PATENT SPECIFICATION

(11) **EP 3 783 626 B1**
(45) Date of publication and mention of the grant of the patent: **03.06.2026**
(21) Application number: 19796171.7
(22) Date of filing: 30.04.2019
(51) Int. Cl.: C09D 11/037, C09D 11/10, C09D 11/52, B22F 1/054, B22F 1/10, B22F 1/16, C09J 175/04, H01B 1/02, H01B 1/22, H05K 1/09, H05K 3/12

(54) **PHOTONIC SINTERED NANOINK, PHOTONIC SINTERING METHOD, AND CONDUCTIVE NANOSTRUCTURE**
PHOTONISCHE GESINTERTE NANOTINTE, PHOTONISCHES SINTERVERFAHREN UND LEITFÄHIGE NANOSTRUKTUR
NANOENCRE FRITTÉE PHOTONIQUE, PROCÉDÉ DE FRITTAGE PHOTONIQUE ET NANOSTRUCTURE CONDUCTRICE

(30) Priority: 02.05.2018 KR 20180050696; 24.05.2018 KR 20180058780
(43) Date of publication of application: 24.02.2021
(73) Proprietor: IUCF-HYU (Industry-University Cooperation Foundation Hanyang University), Seoul 04763 (KR)
(72) Inventor: KIM, Hak-Sung, Seoul 06218 (KR); RYU, Chunghyeon, Jinju-si Gyeongsangnam-do 52729 (KR)
(74) Representative: Prüfer & Partner mbB Patentanwälte · Rechtsanwälte
(86) International application number: PCT/KR2019/005168
(87) International publication number: WO 2019/212218

(56) References cited:
- JP-A- 2014 116 315
- JP-A- 2017 165 796
- KR-A- 20160 101 383
- KR-A- 20160 116 076
- KR-A- 20160 116 076
- KR-A- 20160 132 226
- KR-B1- 101 729 840
- KR-B1- 101 785 350
- KR-B1- 101 799 147
- US-A1- 2009 274 833
- US-A1- 2009 311 440
- US-A1- 2017 118 836

## Description

### 1. Field of the invention

The present invention relates to photo-sintering nano ink, photo-sintering method, and conductive nano structure , and more particularly, to photo-sintering nano ink including copper nano particles, a photo-sintering method, and a conductive nano structure.

### 2. Description of the Related Art

Recently, a print-based printed electronics has been spotlighted in the manufacture of electronic elements or devices. Because an electrode may be formed through the printed electronics by simply performing processes of printing, sintering, and inspection, the smaller number of processes is only required so that the printed electronics may have advantages such as significantly lower equipment investment cost, eco-friendliness, and large-scale mass production compared to the existing photolithography process. In addition, because the printed electronics can be applied to a flexible substrate such as a PET, photopaper, or PI substrate, the printed electronics may be applied to various electronic products such as flexible displays, solar cells, RFID, and flexible electronic products. Currently, conductive ink using gold, silver, and copper nano particles is mainly used to form an electrode of an electronic product. There is a thermal sintering method as a conventional sintering method of conductive nano ink. However, since the sintering is performed at a high temperature of 300°C or higher, thermal sintering method cannot be applied to a flexible substrate that is a next-generation substrate. Accordingly, laser sintering, plasma sintering, microwave sintering, and the like have been disclosed as new sintering methods, however, they are not suitable for mass production. Thus, an intense pulsed white light-sintering method has been developed by the present inventor.

Various developments are being conducted using the disclosed intense pulsed white light-sintering method in an aspect of low-cost conductive nano ink printed on a flexible substrate to manufacture a low-cost electrode. Accordingly, the development of light-sintering-type conductive copper nano ink and paste applied to a high heat-resistant flexible substrate have been actively conducted. However, there is difficulty in applying to a low heat-resistant polymer substrate, which is a low-cost flexible substrate, due to low electrical conductivity and low adhesion. Therefore, it is necessary to develop low-cost conductive copper nano ink sintered on the low heat-resistant polymer substrate in order to reduce the cost of the electrode formed on the flexible substrate.

US 2017/0118836 A1 discloses an ink composition for light sintering and a method of fabricating a wiring board using the same. The ink composition includes copper oxide nanoparticles having copper oxide films, a reducing agent for reducing copper oxidized by light irradiation to form copper nanoparticles, a dispersing agent, a binder, and a solvent.

KR 2016 0132226 describes an ink composition for light sintering, the ink composition including pure copper particles, nano-copper oxide particles having copper oxide films on an outer surface, plate-like silver (Ag) powder, a reductant for reducing the copper oxide film into copper by light irradiation, a dispersant, a binder, and a solvent.

US 2009/274833 A1 describes a metallic ink including a vehicle comprising two or more oxygenated organic compounds, the metallic ink further including copper nanoparticles and a medium length chain aliphatic alcohol. The conductive metallic ink may be deposited on a substrate by methods including inkjet printing and draw-down printing. The ink may be pre-cured and cured to form a conductor on the substrate.

JP 2017 165796 describes a copper nanoparticle ink containing at least a solvent and complex particles where a polymer chain having compatibility with the solvent is chemically bound to a surface oxidation layer of the copper nanoparticles or a surface of copper oxide nanoparticles, and the chemical bond is by silane coupling.

KR 2016 0116076 describes a method of manufacturing a copper printed circuit board, comprising the steps of preparing a paste comprising copper nanoparticles covered with cuprous oxide, printing the paste on a substrate to form a printed circuit pattern, oxidizing said printed circuit pattern so that said copper nanoparticles have a surface coating layer, wherein said surface coating layer is formed to contain cuprous oxide mixed with cupric oxide.

### SUMMARY OF THE INVENTION

The present invention provides photo-sintering nano ink easily light-sintered on a low heat-resistant substrate, a photo-sintering method, and a conductive nano structure.

The present invention further provides photo-sintering nano ink of lower costs, a photo-sintering method, and a conductive nano structure.

The present invention still further provides photo-sintering nano ink improved in electric conductivity, a photo-sintering method, and a conductive nano structure.

The present invention is still further provided to photo-sinter copper nano ink while minimizing damage to a low heat-resistant substrate.

The present invention is still further provided to improve an adhesion force between copper nano ink and a substrate.

The technical problems to be solved by the present invention are not limited to the above.

To solve the above-mentioned technical problems the present invention provides a conductive nano structure according to claim 1, a photo-sintering nano ink according to claim 3, and a photo-sintering method according to claim 8.

According to the invention, the conductive nano structure includes a plurality of conductive nano particles, and an oxide film surrounding each of the plurality of conductive nano particles, wherein the conductive nano particle is a copper nano particle, and the oxide film is made of Cu₂O, wherein the oxide film is formed by oxygen provided on the conductive nano particle at a concentration of 8,000 ppm or more, and less than 17,000 ppm, and wherein a ratio of a thickness of the oxide film to a radial length of the conductive nano particle is 0.1% or more and 8% or less.

According to one embodiment, the oxide film may have the thickness of 0.1 nm or more and 7.8 nm or less.

According to the invention, the photo-sintering nano ink includes a photo-sintering precursor including the conductive nano structure according to the invention, polymer binder resin, and an adhesive.

According to one embodiment, the polymer binder resin may be 0.5 wt% to 5 wt% of the total weight of the photo-sintering nano ink.

According to one embodiment, the polymer binder resin may have a weight average molecular weight of 10,000 to 500,000.

According to one embodiment, the polymer binder resin may include at least one of polyvinylpyrrolidone (PVP), polyvinyl alcohol (PVA), ethyl cellulose (EC), polyvinyl butyral, polyethylene glycol, polymethyl methacrylate, dextran, azobis, and dodecylbenzene sodium sulfate.

According to one embodiment, the adhesive may include at least one of urethane resin, acrylic resin, epoxy resin, epoxy silane, and styrene resin.

According to one embodiment, the photo-sintering method includes preparing photo-sintering nano ink according to the invention; a photo-sintering ink coating step of coating a flexible substrate with the photo-sintering nano ink; and a photo-sintering step of photo-sintering the photo-sintering nano ink coated on the flexible substrate by using white light.

According to one embodiment, in the photo-sintering step, a temperature at which the photo-sintering nano ink coated on the flexible substrate is heated by the white light may be higher than a temperature at which the flexible substrate is heated by the white light.

According to one embodiment, the preparing of the photo-sintering nano ink may include mixing the photo-sintering precursor with a base solution including the polymer binder resin and the adhesive.

### BRIEF DESCRIPTION OF THE DRAWINGS

The above and other objects, features, and advantages of the present invention will be more apparent from the following detailed description taken in conjunction with the accompanying drawings, in which:
FIG. 1 is a flowchart explaining the photo-sintering method according to the embodiment of the present invention.
FIG. 2 is a view showing a conductive nano structure according to the embodiment of the present invention.
FIG. 3 is a view comparing a conductive nanostructure having an oxide film including Cu2O according to the invention shown in Fig. 3(a) with a conductive nanostructure having an oxide film including CuO not according to the invention shown in Fig. 3(b).
FIG. 4 a view showing a photo-sintering process according to the embodiment of the present invention.
FIG. 5 is a graph for pulsed white light used in the photo-sintering method according to the embodiment of the present invention.
FIG. 6 is a photograph of copper nano particles included in the photo-sintering nano ink according to Example 1 of the present invention.
FIG. 7 shows photographs comparing copper nano particles included in the photo-sintering nano ink according to Examples 1 and 2 of the present invention.
FIG. 8 shows photographs comparing photo-sintered states of photo-sintering nano ink according to Examples 1 and 2 of the present invention.
FIG. 9 shows photographs comparing properties of white light applied to photo-sintering nano ink according to time according to the embodiment of the present invention.
FIGS. 10 and 11 show photographs showing tests of the adhesion of photo-sintering nano ink according to Examples and Comparative Examples of the present invention.
FIG. 12 is a graph comparing electrical properties of photo-sintering nano ink according to the embodiments of the present invention.
FIG. 13 is an XRD analysis graph of copper nano particles treated with oxide films included in the photo-sintering nano ink according to Example 1 of the present invention.
FIG. 14 is a graph comparing properties of white light applied to the photo-sintering nano ink according to the embodiment of the present invention, based on time.

### DETAILED DESCRIPTION OF THE EXEMPLARY EMBODIMENTS

Hereinafter, exemplary embodiments of the present invention will be described in detail with reference to the accompanying drawings. However, the technical idea of the present invention is not limited to the exemplary embodiments described herein and may be embodied in other forms. Further, the embodiments disclosed thoroughly and completely herein may be provided such that the idea of the present invention can be fully understood by those skilled in the art.

In the specification, when one component is mentioned as being on another component, it signifies that the one component may be placed directly on another component or a third component may be interposed therebetween. In addition, shapes and sizes in drawings may be exaggerated to effectively describe the technical content of the present invention.

Although terms such as first, second and third are used to describe various components in various embodiments of the present specification, the components should not be limited by the terms. The above terms are used merely to distinguish one component from another. Accordingly, a first component referred to in one embodiment may be referred to as a second component in another embodiment. Each embodiment described and illustrated herein may also include a complementary embodiment. In addition, the term "and/or" is herein used to include at least one of the components listed before and after the term.

The singular expression herein includes a plural expression unless the context clearly specifies otherwise. In addition, it should be understood that the term such as "include" or "have" herein is intended to designate the presence of feature, number, step, component, or a combination thereof recited in the specification, and does not preclude the possibility of the presence or addition of one or more other features, numbers, steps, components, or combinations thereof. In addition, the term "connection" herein is used to include both indirectly connecting a plurality of components and directly connecting the components.

In addition, in the following description of the embodiments of the present invention, the detailed description of known functions and configurations incorporated herein will be omitted when it possibly makes the subject matter of the present invention unclear unnecessarily.

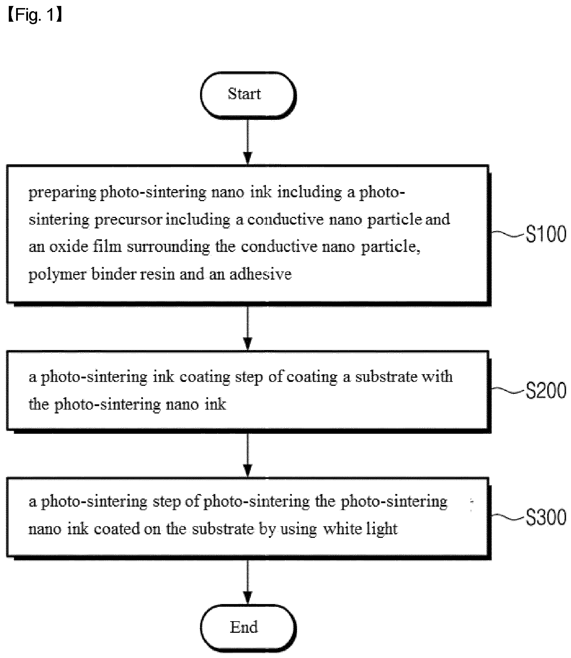

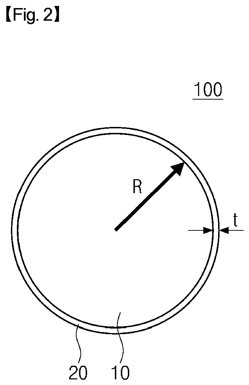

FIG. 1 is a flowchart explaining the photo-sintering method according to the embodiment of the present invention. FIG. 2 is a view showing a conductive nano structure according to the embodiment of the present invention.

Referring to FIGS. 1 and 2, photo-sintering nano ink is prepared (S100). According to one embodiment, the preparing (S100) of the photo-sintering nano ink may include preparing a conductive nano particle 10, forming an oxide film 20 on the conductive nano particle 10 by providing oxygen, and mixing the conductive nano particle 10 on which the oxide film 20 is formed with a base solution.

According to one embodiment, when the oxide film 20 is formed by providing oxygen to the conductive nano particle, the oxide film 20 may surround the conductive nano particle 10. Accordingly, a conductive nano structure 100 may be formed. In other words, the photo-sintering nano ink may be formed by mixing the base solution with the conductive nanostructure 100 according to the embodiment. In other words, the conductive nano structure 100 may be used as a photo-sintering precursor for preparing the photo-sintering nano ink.

According to one embodiment, the oxide film 20 may function to maximize sintering of the photo-sintering nano particles while minimizing damage to the low heat-resistant substrate, in the photo-sintering step described later.

According to the related art, the low heat-resistance substrate is damaged by photo-sintering energy applied for sintering the photo-sintering nano particle. In other words, the photo-sintering energy required for sintering the photo-sintering nano particles may cause damage to the low heat-resistant substrate.

In addition, according to the related art, it is difficult to achieve smooth sintering when photo-sintering energy having low intensity is applied to avoid the damage to the low heat-resistant substrate. This is because the temperature of the nano particles cannot rise to the extent that sintering occurs.

In other words, according to the related art, since the quality of sintering and the prevention of damage to the low heat-resistant substrate are in a trade-off relationship, there is a difficulty in applying a light-sintering process to the low heat-resistant substrate.

However, according to one embodiment of the present invention, even when the photo-sintering energy having low intensity is applied, the oxide film 20 may function to increase the temperature of the photo-sintering nano particle when the oxide film 20 surrounds the photo-sintering nano particle. Accordingly, the quality of sintering the nano particles may be improved. In addition, since the photo-sintering energy applied to the low heat-resistant substrate is at a low level, the damage to the substrate may also be minimized. The quality of sintering may be improved while preventing the damage to the low heat-resistant substrate.

The low heat-resistant substrate may refers to a substrate formed of a material having a glass transition temperature (Tg) of 200 degrees or less, for example, polymer such as PES, PC, PET, and PEN.

According to one embodiment, a thickness t of the oxide film 20 and the ratio (t/R, %) of the thickness t of the oxide film 20 to a radius length R of the conductive nano particle 10 may be controlled. Specifically, the thickness of the oxide film 20 may be controlled to be 0.1 nm or more and 7.8 nm or less. In addition, the ratio (t/R) of the thickness t of the oxide film 20 to the radius length R of the conductive nano particle 10 may be controlled to be 0.1% or more and 8% or less. Accordingly, the photo-sintering nano ink may be easily photo-sintered even in low energy white light.

In contrast, when the thickness of the oxide film 20 is less than 0.1 nm or the ratio (t/R) of the thickness t of the oxide film 20 to the radius length R of the conductive nano particle 10 is less than 0.1%, the thickness of the oxide film 20 is excessively thin, and thus the substrate may not be prevented from being damaged by the white light. In other words, since the energy of white light required for sintering the nano particle 10 is not sufficiently lowered, the substrate 10 may have a risk to be damaged. In addition, when the thickness of the oxide film 20 is more than 7.8 nm or the ratio (t/R) of the thickness t of the oxide film 20 to the radius length R of the conductive nano particle 10 is more than 8%, the thickness of the oxide film 20 is excessively thick, and thus the photo-sintering may not be easily performed.

According to one embodiment, the concentration of oxygen provided to the conductive nano particle 10 may be controlled in order to control the thickness t of the oxide film 20 and the ratio (t/R, %) of the thickness t of the oxide film 20 to the radius length R of the conductive nano particle 10. For example, the concentration of oxygen provided to the conductive nano particle 10 may be 8000 ppm or more and less than 17000 ppm. In this case, the thickness t of the oxide film 20 and the ratio (t/R) of the thickness t of the oxide film 20 to the radius length R of the conductive nano particle 10 may be controlled within the above-described range.

In addition, unlike the above description, when the concentration of oxygen provided to the conductive nano particle 10 is 17000 ppm or more, the thickness of the oxide film 20 is excessively thick, and thus a large number of pores may be formed in the photo-sintering nano ink during the photo-sintering step described later. When a large number of pores are formed in the photo-sintering nano ink, there may be a problem that the conductivity is lowered.

According to one embodiment, the conductive nano particle may be a copper nano particle. When the copper nano particle is used as the conductive nano particle, the light sintering method according to the embodiment may have an economic advantage.

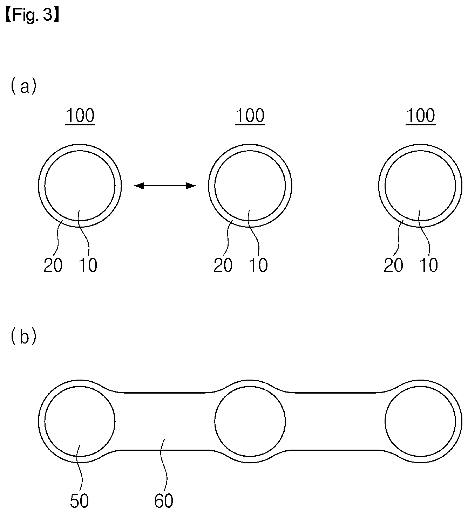

The oxide film formed by providing the oxygen to the copper nano particle may contain Cu2O. In contrast, when the oxide film contains CuO the conductive nano particle may exceed a nano size. More specific details of the above description will be described with reference to FIG. 3.

FIG. 3 is a view comparing a conductive nanostructure having an oxide film including Cu2O with a conductive nanostructure having an oxide film including CuO according to the embodiment of the present invention.

Referring to FIG. 3(a), when a plurality of conductive nano particles 10 and oxide films 20 including Cu2O are provided, the oxide films 20 in the conductive nano structure 100 according to the embodiment may surround the conductive nano particles 10, respectively. Accordingly, the same number of conductive nanostructures 100 as the conductive nano particles 10 may be formed. In addition, the formed conductive nano structure 100 may be spaced apart from each other. As a result, the conductive nano structure 100 according to the embodiment may have a nano size.

In contrast, referring to FIG. 3(b), when a plurality of conductive nano particles 50 and oxide films 60 including CuO are provided, the oxide film 60 including CuO may simultaneously surround the conductive nano particles 50. Accordingly, when the number of conductive nano particles 50 is increased, the oxide film 60 including CuO surrounds all the conductive nano particles 50, so the size of the oxide film 60 may be increased. As a result, when the oxide film of the conductive nanostructure includes CuO, the conductive nanostructure may become larger than the nano size.

According to one embodiment, the base solution may include dispersant, solvent, polymer binder resin, and an adhesive. For example, the dispersant may include at least one of copolymer including an ionic group such as Disperbyk 180, Disperbyk 111, and styrene maleic anhydride copolymer (SMA 1440flake), 2-butoxyethyl acetate, propylene glycol monomethyl ether acetate, diethylene glycol monoethyl ether acetate, ethylene glycol butyl ether, cyclohexanone, cyclohexanol, 2-ethoxyethyl acetate, ethylene glycol diacetate, A-terpineol, isobutyl alcohol, and diethyllene glycol butyl ether (DEGBE).

For example, the solvent may include at least one of ethylene glycol, diethylene glycol, triethylene glycol, poly-ethylene glycol, propylene glycol, dipropylene glycol, hexylene glycol, glycerine, iso-propyl alcohol, 2-methoxy ethanol, pentyl alcohol, hexyl alcohol, butyl alcohol, octyl alcohol, formaldehyde, methyl ethyl ketone, ethyl alcohol, methyl alcohol, and acetone.

For example, the polymer binder resin may include at least one of ethyl cellulose (EC), polyvinylpyrrolidone (PVP), polyvinyl alcohol (PVA), polyvinyl butyral, polyethylene glycol, polymethyl methacrylate, dextran, azobis and dodecylbenzene sodium sulfate.

The polymer binder resin may function as a reducing agent. Particularly, the polymer binder resin may perform a function of reducing the oxide film. More specifically, when the photo-sintering energy is applied to the polymer binder resin, for example, ethylcellulose (EC), alcohol-based gas may be generated as ethylcellulose (EC) is decomposed. The generated alcohol-based gas may reduce the oxide film. Accordingly, the nano particle having the reduced oxide film may be sintered. In another aspect, when the photo-sintering energy is applied to the nano particle, the oxide film may serve to lock in the photo-sintering energy applied to the nano particle, thereby enabling the temperature of the nano particle to reach the temperature required for sintering, and then the oxide film may be removed by a reducing agent.

According to one embodiment, the polymer binder resin may be 0.5 wt% to 5 wt% compared to the total weight of the photo-sintering nano ink. In addition, the polymer binder resin may have a weight average molecular weight of 10,000 to 500,000. In contrast, when the polymer binder resin is less than 0.5 wt% relative to the total weight of the photo-sintering nano ink, or has a weight average molecular weight less than 10,000, the polymer binder resin may not be easily dispersed in the base solution. In contrast, when the polymer binder resin is more than 0.5 wt% relative to the total weight of the photo-sintering nano ink, or has a weight average molecular weight more than 500,000, the polymer binder resin may aggregate in the base solution.

For example, the adhesive may include at least one of urethane resin, acrylic resin, epoxy resin, epoxy silane, and styrene resin. Specifically, the adhesive may include polyurethane diol (PUD).

According to one embodiment, the adhesive may prevent heat generated from the photo-sintering nano ink from being transferred to the substrate in the photo-sintering step described later. Accordingly, the adhesive may prevent a thermal deformation of the substrate. In addition, the adhesive may improve adhesion between the photo-sintering nano ink and the substrate, thereby providing excellent strength and rigidity. As a result, when the photo-sintering nano ink according to the embodiment includes the adhesive, a polymer substrate having low heat-resistant properties may be used in the photo-sintering step.

The low heat-resistant substrate may refers to a substrate formed of a material having a glass transition temperature (Tg) of 200 degrees or less, for example, polymer such as PES, PC, PET, and PEN, as described above.

The flexible substrate, which is a next-generation substrate, has low heat-resistant properties. The low heat-resistant substrate may be deformed by high temperature heat generated in the photo-sintering step. However, as described above, the adhesive may prevent the heat generated in the photo-sintering step from being transferred to the substrate. Accordingly, when the photo-sintering nano ink according to the embodiment includes the adhesive, the substrates having low heat-resistant properties may be used in the photo-sintering process.

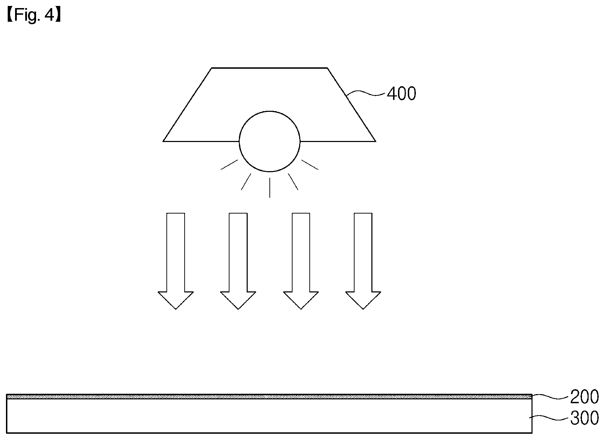

FIG. 4 is a view showing a photo-sintering process according to an embodiment of the present invention.

Referring to FIGS. 1 and 4, the photo-sintering nano ink 200 may be coated on the substrate 300 (S200). For example, the substrate 300 may be one of photo paper, PET, paper, polybutylene terephthalate, polyethylene terephthalate, polysulfone, polyether, polyetherimide, polyethylene naphthalate (PEN), acrylic resin, heat-resistant epoxy, BT epoxy/glass fiber, acetic acid vinyl resin (EVA), butyl rubber resin, polyarylate, and polyimide.

According to one embodiment, the photo-sintering nano ink 200 may be coated on the substrate 300 through screen printing, inkjet printing, micro-contact printing, imprinting, gravure printing, gravure-offset printing, flexography printing, spin coating, or the like.

After the photo-sintering nano ink 200 is coated on the substrate 300, the photo-sintering nano ink 200 may be dried. For example, the photo-sintering nano ink 200 may be dried in any one scheme among NIR irradiation, hot air fan, oven (heat chamber), hot plate, and infrared irradiation.

According to one embodiment, in the step of drying the photo-sintering nano ink 200, the drying temperature may be maintained at 60°C to 150°C. In contrast, when the drying temperature is less than 60°C, the photo-sintering nano ink 200 may be insufficiently dried. In contrast, when the drying temperature exceeds 150°C, the substrate 300 may be damaged. As described above when the photo-sintering nano ink 200 is insufficiently dried or the substrate 300 is damaged, the light sintering described later may not be easily performed.

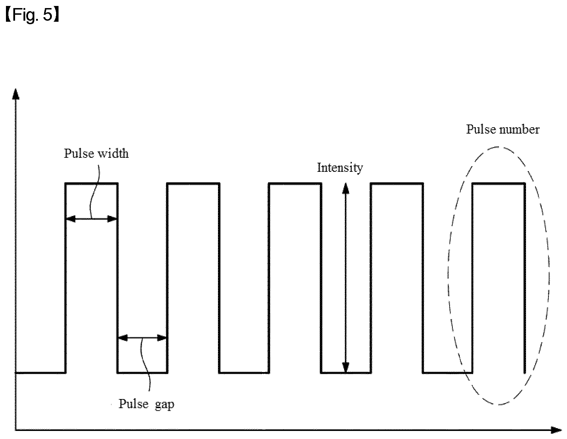

Next, the photo-sintering nano ink 200 may be photo-sintered by irradiation with intense pulsed white light (S300). The intense pulsed white light may be irradiated from a light source 400. For example, the light source 400 may be a xenon flash lamp. Step S300 will be described in detail with reference to FIG. 5.

FIG. 5 is a graph for pulsed white light used in the photo-sintering method according to the embodiment of the present invention.

Referring to FIG. 5, in the light sintering step (S300), a pulse width of the light source 400 may be 0.01 ms to 100 ms. A pulse gap of the light source 400 may be 0.01 ms to 10 ms. A pulse number of the light source 400 may be 1 time to 100 times. An intensity of the light source 400 may be 0.1 J/cm2 to 100 J/cm2. The intensity of the light source 400 may vary according to a type of the substrate 300. For example, when the substrate 300 is a PET substrate, the intensity of the light source 400 may be 1 to J/cm2 to 5 J/cm2. In contrast, when the substrate 300 is a PI substrate, the intensity of the light source 400 may be 5 J/cm2 to 20 J/cm2.

When the pulse width of the light source 400 is greater than 100 ms, it is uneconomical because incident energy per unit time may decrease and the sintering efficiency may be lowered. When the pulse gap is greater than 10 ms or the pulse number is greater than 100 times, and even when the intensity is less than 0.1 J/cm2, the photo-sintering ink 300 cannot be sintered due to excessively low energy. When the pulse gap is less than 0.01 ms or the intensity is greater than 100 J/cm2, the lamp and equipment are excessively burdened and thus and lifespans of the lamp and equipment may be rapidly shortened.

The light sintering method according to the embodiments of the present invention may include preparing the photo-sintering nano ink 200 including a photo-sintering precursor including the conductive nano particle 10 and the oxide film 20 surrounding the conductive nano particle, the polymer binder resin, and the adhesive; the photo-sintering ink coating step of coating the photo-sintering nano ink 200 on the substrate 300; and the photo-sintering step of photo-sintering the photo-sintering nano ink coated on the substrate 300 by using white light. In the preparing of the photo-sintering nano ink, the conductive nano particle 10 may include a copper nano particle, and the oxide film 20 may include Cu2O.

Further, in the light sintering method according to the embodiments of the present invention, when the conductive nano particle 10 included in the photo-sintering nano ink is surrounded by the oxide film 20, the light sintering may be easily performed even by white light having low energy. As a result, the light-sintering method may be provided to be easily applicable to a substrate having low heat-resistant properties such as a flexible substrate.

The photo-sintering nano ink, the photo-sintering method, and the conductive nano structure according to the embodiments of the present invention have been described. Hereinafter, results on specific experimental examples and characteristic evaluations, of the photo-sintering nano ink, the photo-sintering method, and the conductive nano structure according to the embodiments of the present invention, will be described.

### Photo-sintering Nano Ink and Light Sintering according To Example 1

First, 1.85 g of diethylene glycol butyl ether (DEGBE), 1 g of ethylene glycol (EG), 1 g of A-terienol, 0.15 g of ethylcellulose (EC), and 0.3 g of oolyurethane diol (PUD) are mixed and then dispersed using a sonicator, so that a base solution was prepared.

Next, 16 g of copper nano particles (Ning-guangbo. diameter: 180 nm) treated by oxide films with an oxygen concentration of 8000 ppm are added to the base solution, and then dispersed using a 3-roll mill for 1 hour, thereby preparating the photo-sintering nano ink according to Example 1.

The prepared photo-sintering nano ink according to Example 1 was printed on a PET substrate having a thickness of 50 µm by using a screen printer at a speed of 100 mm/s, dried using infrared rays having a temperature of 100°C, and irradiated with intense pulsed white light, thereby light-sintering the photo-sintering nano ink according to Example 1. The number of pulses of the intense pulsed white light is 1, a pulse width is 2 ms, and photo-sintering energy is 3 J/cm2.

### Photo-sintering Nano Ink And photo-sintering According To Example 2

The base solution described in the prepairing method of the photo-sintering nano ink according to Example 1 is prepared.

Next, 16 g of copper nano particles (Poongsan. diameter: 100 nm) treated by oxide films with an oxygen concentration of 17000 ppm are added to the base solution, and then dispersed using the 3-roll mill for 1 hour, thereby preparating the photo-sintering nano ink according to Example 2.

The prepared photo-sintering nano ink according to Example 2 was printed on a PET substrate having a thickness of 50 µm by using a screen printer at a speed of 100 mm/s, dried using infrared rays having a temperature of 100°C, and irradiated with intense pulsed white light, thereby light-sintering the photo-sintering nano ink according to Example 2. The number of pulses of the intense pulsed white light is 1, a pulse width is 2 ms, and photo-sintering energy is 3 J/cm2.

### Photo-sintering Nano Ink And photo-sintering According To Example 3

The base solution described in the prepairing method of the photo-sintering nano ink according to Example 1 is prepared.

Next, 16 g of copper nano particles (Ning-guangbo. diameter: 180 nm) treated by oxide films with an oxygen concentration of 8000 ppm are added to the base solution, and then dispersed using the 3-roll mill for 1 hour, thereby preparating the photo-sintering nano ink according to Example 3.

The prepared photo-sintering nano ink according to Example 3 was printed on a PI substrate having a thickness of 25 µm by using a screen printer at a speed of 100 mm/s, dried using infrared rays having a temperature of 100°C, and irradiated with intense pulsed white light, thereby light-sintering the photo-sintering nano ink according to Example 3. The number of pulses of the intense pulsed white light is 1, a pulse width is 5 ms, and photo-sintering energy is 6 J/cm2.

### Photo-sintering Nano Ink And photo-sintering According To Example 4

The base solution described in the prepairing method of the photo-sintering nano ink according to Example 1 is prepared.

Next, 16 g of copper nano particles (Poongsan. diameter: 100 nm) treated by oxide films with an oxygen concentration of 17000 ppm are added to the base solution, and then dispersed using the 3-roll mill for 1 hour, thereby preparating the photo-sintering nano ink according to Example 4.

The prepared photo-sintering nano ink according to Example 4 was printed on a PI substrate having a thickness of 25 µm by using a screen printer at a speed of 100 mm/s, dried using infrared rays having a temperature of 100°C, and irradiated with intense pulsed white light, thereby light-sintering the photo-sintering nano ink according to Example 4. The number of pulses of the intense pulsed white light is 1, a pulse width is 5 ms, and photo-sintering energy is 6 J/cm2.

### Photo-sintering Nano Ink And photo-sintering According To Example 5

The base solution described in the prepairing method of the photo-sintering nano ink according to Example 1 is prepared.

Next, 16 g of copper nano particles (Ning-guangbo. diameter: 180 nm) treated by oxide films with an oxygen concentration of 8000 ppm are added to the base solution, and then dispersed using the 3-roll mill for 1 hour, thereby preparating the photo-sintering nano ink according to Example 5.

The prepared photo-sintering nano ink according to Example 4 was printed on a PET substrate having a thickness of 50 µm by using a screen printer at a speed of 100 mm/s, dried using infrared rays having a temperature of 100°C, and irradiated with intense pulsed white light, thereby light-sintering the photo-sintering nano ink according to Example 4. The number of pulses of the intense pulsed white light is 1, a pulse width is 5 ms, and photo-sintering energy is 3 J/cm2.

### Photo-sintering Nano Ink and photo-sintering according To Example 1

First, 1.85 g of diethylene glycol butyl ether (DEGBE), 1 g of ethylene glycol (EG), 1 g of A-terienol, and 0.15 g of ethylcellulose (EC) are mixed and then dispersed using a sonicator, so that a base solution was prepared.

Next, 16 g of copper nano particles (Ning-guangbo. diameter: 180 nm) treated by oxide films with an oxygen concentration of 8000 ppm are added to the base solution, and then dispersed using the 3-roll mill for 1 hour, thereby preparating the photo-sintering nano ink according to Comparative Example 1.

The prepared photo-sintering nano ink according to Comparative Example 1 was printed on a PET substrate having a thickness of 50 µm by using a screen printer at a speed of 100 mm/s, dried using infrared rays having a temperature of 100°C, and irradiated with intense pulsed white light, thereby light-sintering the photo-sintering nano ink according to Comparative Example 1. The number of pulses of the intense pulsed white light is 1, a pulse width is 2 ms, and photo-sintering energy is 3 J/cm2.

The light-sintering nano ink and light-sintering conditions according to Examples 1 to 5 and Comparative Example 1 will be summarized through Table 1 as follows.

**<Table 1>**

| Item | PUD | Oxygen | Substrate | Photo-sintering |
|---|---|---|---|---|
| | inclu ded | concentr ation | type | condition |
| Exam ple 1 | ○ | 8000 ppm | PET | Number of pulses is 1, Pulse width is 2 ms, and Energy is 3 J/cm2. |
| Exam ple 2 | ○ | 17000 ppm | PET | Number of pulses is 1, Pulse width is 2 ms, and Energy is 3 J/cm2. |
| Exam ple 3 | ○ | 8000 ppm | PI | Number of pulses is 1, Pulse width is 5 ms, and Energy is 6 J/cm2. |
| Exam ple 4 | ○ | 17000 ppm | PI | Number of pulses is 1, Pulse width is 5 ms, and Energy is 6 J/cm2. |
| Exam ple 5 | ○ | 8000 ppm | PET | Number of pulses is 1, Pulse width is 5 ms, and Energy is 3 J/cm2 |
| Comp arat ive Exam ple l | X | 8000 ppm | PET | Number of pulses is 1, Pulse width is 2 ms, and Energy is 3 J/cm2. |

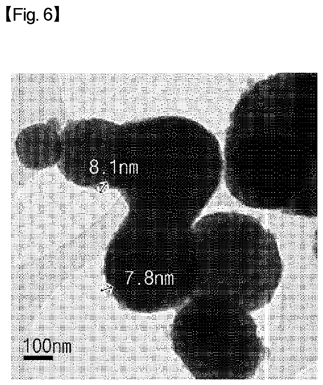

FIG. 6 is a photograph of copper nano particles included in the photo-sintering nano ink according to Example 1 of the present invention.

Referring to FIG. 6, the copper nano particles included in the photo-sintering nano ink according to Example 1 were photographed using a transmission electron microscope (TEM). As shown in FIG. 6, it was confirmed that the copper nano particles treated with oxide films with an oxygen concentration of 8000 ppm has an average thickness of the oxide films is 7.8 nm to 8.1 nm, and accordingly the ratio of the thickness of the oxide film to the radius length of the copper nano particle was 8% or less.

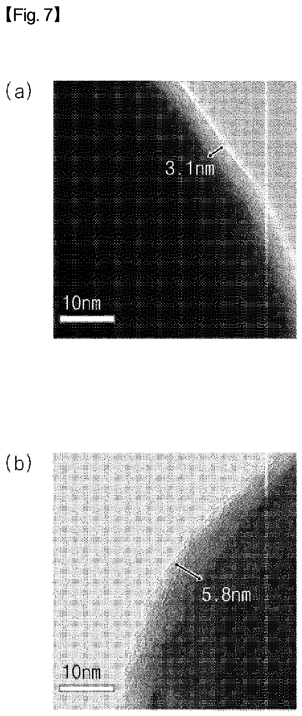

FIG. 7 shows photographs comparing copper nano particles included in the photo-sintering nano ink according to Examples 1 and 2 of the present invention.

Referring to FIGS. 7(a) and 7(b), the copper nano particles included in the photo-sintering nano ink according to Examples 1 and 2 were photographed using an HR-TEM. As shown in FIG. 7(a), it was confirmed that the copper nano particles included in the photo-sintering nano ink according to Example 1 has the thickness of the oxide film indicated to be about 3.1 nm. In addition, as shown in FIG. 7(b), it was confirmed that the copper nano particles included in the photo-sintering nano ink according to Example 2 has the thickness of the oxide film indicated to be about 5.1 nm.

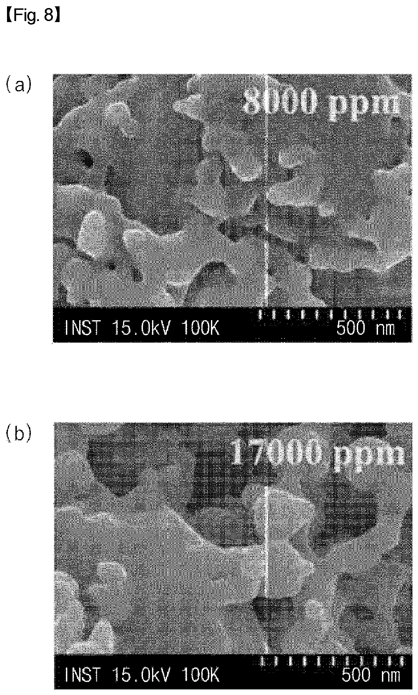

FIG. 8 shows photographs comparing photo-sintered states of photo-sintering nano ink according to Examples 1 and 2 of the present invention.

Referring to FIGS. 8(a) and 8(b), photo-sintered states of the photo-sintering nano ink according to Examples 1 and 2 were photographed using a scanning electron microscope (SEM). As shown in FIG. 8(a), it was confirmed that there were almost no pores after sintering when the photo-sintering nano ink according to Example 1 is photo-sintered. In contrast, as shown in FIG. 8(b), it was confirmed that pores were formed after sintering when the photo-sintering nano ink according to Example 2 is photo-sintered. Accordingly, it can be seen that the concentration of oxygen treated to form the oxide film of the copper nano particle is required to be controlled at 8000 ppm or more and less than 17000 ppm, in the case of preparing the photo-sintering nano ink according to the embodiments of the present invention.

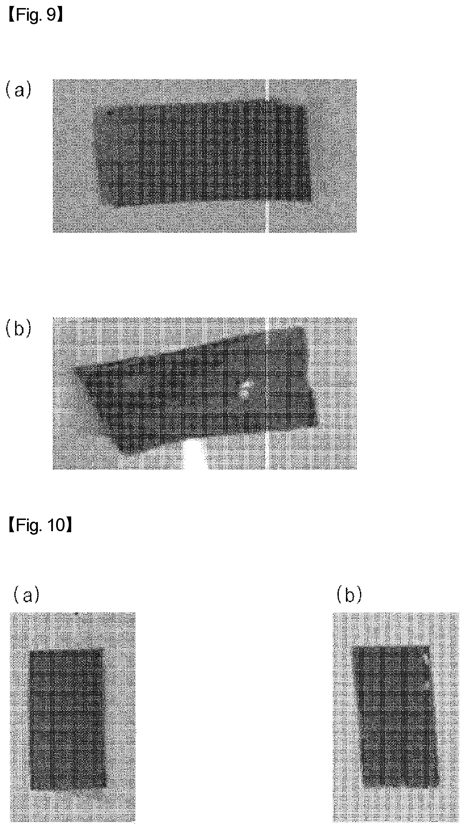

FIG. 9 shows photographs comparing properties of white light applied to photo-sintering nano ink according to the embodiment of the present invention, based on time.

Referring to FIGS. 9(a) and 9(b), photo-sintered states of the photo-sintering nano ink according to Examples 1 and 5. As shown in FIG. 9(a), it can be confirmed that the sintering was sufficiently performed to be a pink color when white light is applied to the photo-sintering nano ink for 2 ms. In contrast, as shown in FIG. 9(b), it can be confirmed that a lot of warpage were generated on the substrate and the sintering was not sufficiently performed, when the white light is applied to the photo-sintering nano ink for 5 ms. Accordingly, it can be seen that, when the photo-sintering is performed on a PET substrate using the photo-sintering nano ink according to the embodiment, the light-sintering may be easily performed when the time for applying the white light to the photo-sintering nano ink is controlled to be 0.01 ms or more and less than 5 ms.

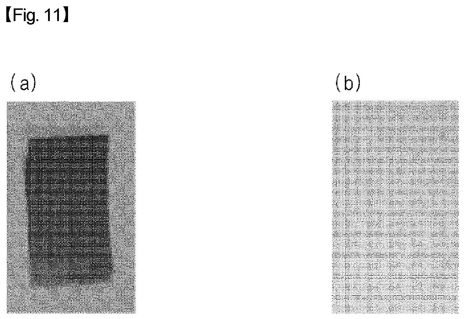

FIGS. 10 and 11 show photographs showing tests of the adhesion of photo-sintering nano ink according to Examples and Comparative Examples of the present invention.

Referring to FIGS. 10(a) and 10(b), after the photo-sintering nano ink according to Comparative Example 1 is photo-sintered, the adhesion of the photo-sintering nano ink according to Comparative Example 1 was tested by using an adhesive tape having an adhesive force of 0B. FIG. 10(a) is a photograph of the photo-sintered photo-sintering nano ink according to Comparative Example 1, and FIG. 10(b) is a photograph of a result of performing the adhesion test using the adhesive tape having the adhesive strength of 0B with respect to the photo-sintered photo-sintering nano ink according to Comparative Example 1.

As shown in FIG. 10(b), in the case of photo-sintering nano ink according to Comparative Example 1, it was confirmed that most of the photo-sintering nano ink according to Comparative Example 1 were stained on the adhesive tape having the adhesive force of 0B. In other words, it can be seen that the photo-sintering nano ink according to Comparative Example 1 has a low adhesion force.

Referring to FIGS. 11(a) and 11(b), after the photo-sintering nano ink according to Example 1 was photo-sintered, the adhesion of the photo-sintering nano ink according to Example 1 was tested by using an adhesive tape having an adhesive force of 5B. FIG. 11(a) is a photograph of the photo-sintered photo-sintering nano ink according to Example 1, and FIG. 11(b) is a photograph of a result of performing the adhesion test using the adhesive tape having the adhesive strength of 5B with respect to the photo-sintered photo-sintering nano ink according to Example 1.

As shown in FIG. 11(b), in the case of photo-sintering nano ink according to Example 1, it was confirmed that the photo-sintering nano ink according to Example 1 was not stained on the adhesive tape having the adhesive force of 5B. In other words, it was confirmed that the ink was not stained out even when the adhesion test was performed using the adhesive tape having the adhesion force higher than the adhesive tape used in the adhesion test of the photo-sintering nano ink according to Comparative Example 1. Accordingly, it can be seen that the photo-sintering nano ink according to Example 1 has an excellent adhesion force.

As a result, FIGS. 10 and 11 show that, in the case of preparing the photo-sintering nano ink according to the embodiments of the present invention, the inclusion of an adhesive such as PUD is a way to improve the adhesion between the substrate and the photo-sintering nano ink.

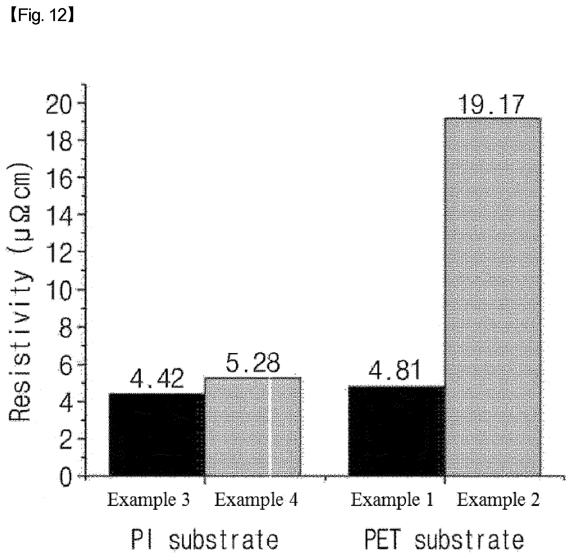

FIG. 12 is a graph comparing electrical properties of photo-sintering nano ink according to the embodiments of the present invention.

Referring to FIG. 12, the resistivity (µΩcm) of the photo-sintering nano ink was measured and shown according to Examples 1 to 4. As shown in FIG. 12, it was confirmed that photo-sintering nano ink according to Examples 3 and 4 exhibited similar resistivity, but the photo-sintering nano ink according to Examples 1 and 2 exhibited a significant difference in resistivity.

In other words, it can be seen that, when oxygen for forming the oxide film of the copper nano particles included in the photo-sintering nano ink has different concentrations of 8000 ppm and 17000 ppm, the PI substrate exhibited a slight difference in resistivity, but the PET substrate exhibited a remarkable difference.

Accordingly, it can be seen that, in the case of preparing the photo-sintering nano ink according to the embodiments of the present invention, the concentration of oxygen treated to form the oxide film of the copper nano particle is required to be controlled at 8000 ppm or more and less than 17000 ppm. In addition, it can be seen that the concentration of oxygen may be controlled according to a glass transition temperature of a target substrate.

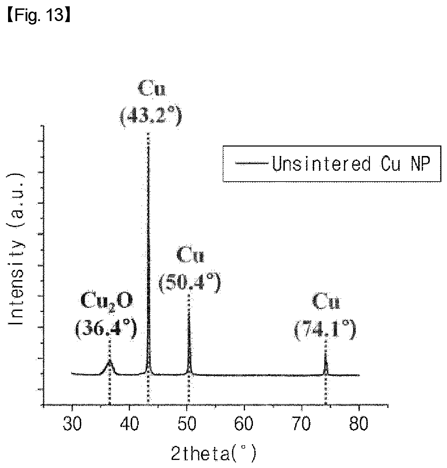

FIG. 13 is an XRD analysis graph of copper nano particles treated with oxide films included in the photo-sintering nano ink according to Example 1 of the present invention.

Referring to FIG. 13, the intensity (a.u.) according to 2 theta (°) of copper nano particles treated with oxide films included in the photo-sintering nano ink according to Example 1 was measured. As shown in FIG. 13, it can be seen that the copper nano particles treated with oxide films included in the photo-sintering nano ink according to Example 1 includes only Cu2O in the oxide film.

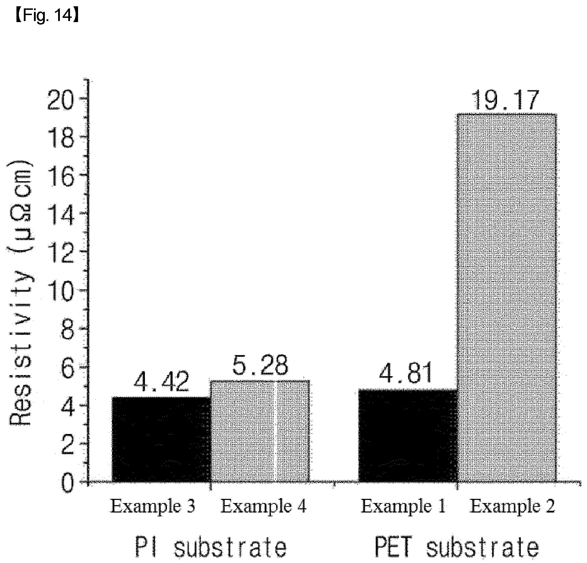

FIG. 14 is a graph comparing properties of white light applied to the photo-sintering nano ink according to the embodiment of the present invention, based on time.

Referring to FIG. 14, when the photo-sintering nano ink is photo-sintered according to Examples 1 and 5, the warpage of the substrate was measured and shown. As shown in FIG. 14, it can be confirmed that the warpage of the substrate was significantly generated in the photo-sintering nano ink according to Example 5, compared to the photo-sintering nano ink according to Example 1. In other words, it can be confirmed that, when the white light is applied to the photo-sintering nano ink for 5 ms, the warpage of the substrate significantly was increased compared to the case of 2 ms. Accordingly, it can be seen that, when the photo-sintering is performed on a PET substrate using the photo-sintering nano ink according to the embodiment, the light-sintering may be easily performed when the time for applying the white light to the photo-sintering nano ink is controlled to be 0.01 ms or more and less than 5 ms.

According to the above-described embodiments of the present invention, the light sintering process can be performed on a low heat-resistant substrate. In other words, the oxide film is formed on the surface of the nano particle, so that the temperature of the nano particle can be increased to the degree required for sintering even when the light sintering energy intensity is lowered. The oxide film of the copper nano particle may be formed of a copper oxide film. In other words, the oxide film may be formed based on the same component as that of the nano particle.

Particularly, according to one embodiment of the present invention, the oxide film may be formed of Cu2O. When CuO is used as an oxide film as in the above-described manner, it may be chemically stable, but photo-sintering nano particles may form a lump, thereby deteriorating the quality of photo-sintering. However, the present invention has experimentally proved that a photo-sintered electrode having a low-resistance can be manufactured on a low heat-resistant substrate by applying Cu2O as the oxide film.

Meanwhile, when the nano ink includes the adhesive, the adhesive can function to block the photo-sintering energy applied to the substrate. Accordingly, the damage to the low heat-resistant substrate can be minimized. In another aspect, since the low heat-resistant substrate may be protected by the adhesive it is meaningful that the intensity of photo-sintering energy can be increased. Further, the adhesion force between the substrate and the photo-sintering nano particle, that is, the electrode can be remarkably improved due to the adhesive. Accordingly, mechanically robust properties may be provided even in a flexible environment.

Meanwhile, the thickness of the oxide film may be controlled according to properties of the substrate, and may be simply controlled by adjusting the oxygen flow rate.

Although the present invention has been described in detail using exemplary embodiments, the scope of the invention is not limited to the specific embodiments, and shall be interpreted by the appended claims. In addition, it will be apparent that a person having ordinary skill in the art may carry out various deformations and modifications for the embodiments described as above within the scope without departing from the present invention.

## Claims

1. A conductive nano structure (100) comprising:
a plurality of conductive nano particles (10); and
an oxide film (20) surrounding each of the plurality of conductive nano particles (10),
wherein the conductive nano particle (10) is a copper nano particle, and the oxide film (20) is made of Cu₂O,
wherein the oxide film is formed by oxygen provided on the conductive nano particle (10) at a concentration of 8,000 ppm or more, and less than 17,000 ppm, and
wherein a ratio of a thickness of the oxide film (20) to a radial length of the conductive nano particle (10) is 0.1% or more and 8% or less.

2. The conductive nano structure of claim 1, wherein the oxide film (20) has a thickness of 0.1 nm or more and 7.8 nm or less.

3. A photo-sintering nano ink (200) comprising:
a photo-sintering precursor including the conductive nano structure (100) as claimed in one of claims 1 and 2;
polymer binder resin; and
an adhesive.

4. The photo-sintering nano ink of claim 3, wherein the polymer binder resin is 0.5 wt% to 5 wt% based on a total weight of the photo-sintering nano ink (200).

5. The photo-sintering nano ink of claim 3, wherein the polymer binder resin has a weight average molecular weight of 10,000 to 500,000.

6. The photo-sintering nano ink of claim 3, wherein the polymer binder resin includes at least one of polyvinylpyrrolidone (PVP), polyvinyl alcohol (PVA), ethyl cellulose (EC), polyvinyl butyral, polyethylene glycol, polymethyl methacrylate, dextran, azobis, and dodecylbenzene sodium sulfate.

7. The photo-sintering nano ink of claim 3, wherein the adhesive includes at least one of urethane resin, acrylic resin, epoxy resin, epoxy silane, and styrene resin.

8. A photo-sintering method comprising:
preparing photo-sintering nano ink (200) as claimed in one of claims 3 to 7;
a photo-sintering ink coating step of coating a flexible substrate (300) with the photo-sintering nano ink (200); and
a photo-sintering step of photo-sintering the photo-sintering nano ink coated on the flexible substrate by using white light.

9. The photo-sintering method of claim 8, wherein, in the photo-sintering step, a temperature at which the photo-sintering nano ink (200) coated on the flexible substrate (300) is heated by the white light is higher than a temperature at which the flexible substrate is heated by the white light.

10. The photo-sintering method of claim 8, wherein, the preparing of the photo-sintering nano ink (200) includes
mixing the photo-sintering precursor with a base solution including the polymer binder resin and the adhesive.

## Patentansprüche

1. Leitfähige Nanostruktur (100), umfassend:
eine Mehrzahl von leitfähigen Nanopartikeln (10); und
eine Oxidschicht (20), die jedes der Mehrzahl von leitfähigen Nanopartikeln (10) umgibt,
wobei das leitfähige Nanopartikel (10) ein Kupfer-Nanopartikel ist und die Oxidschicht (20) aus Cu₂O besteht,
wobei die Oxidschicht durch Sauerstoff gebildet ist, der auf dem leitfähigen Nanopartikel (10) in einer Konzentration von 8.000 ppm oder mehr und weniger als 17.000 ppm vorgesehen ist, und
wobei ein Verhältnis einer Dicke der Oxidschicht (20) zu einer radialen Länge des leitfähigen Nanopartikels (10) 0,1 % oder mehr und 8 % oder weniger beträgt.

2. Leitfähige Nanostruktur nach Anspruch 1, wobei die Oxidschicht (20) eine Dicke von 0,1 nm oder mehr und 7,8 nm oder weniger aufweist.

3. Fotosinterbare Nano-Tinte (200), umfassend:
einen Fotosinter-Vorläufer, der eine leitfähige Nanostruktur (100) nach einem der Ansprüche 1 und 2 enthält;
ein Polymerbindemittelharz; und
einen Klebstoff.

4. Fotosinterbare Nano-Tinte nach Anspruch 3, wobei das Polymerbindemittelharz 0,5 Gew.-% bis 5 Gew.-%, basierend auf einem Gesamtgewicht der fotosinterbaren Nano-Tinte (200), beträgt.

5. Fotosinterbare Nano-Tinte nach Anspruch 3, wobei das Polymerbindemittelharz ein gewichtsmittleres Molekulargewicht von 10.000 bis 500.000 aufweist.

6. Fotosinterbare Nano-Tinte nach Anspruch 3, wobei das Polymerbindemittelharz mindestens eines der folgenden umfasst: Polyvinylpyrrolidon (PVP), Polyvinylalkohol (PVA), Ethylcellulose (EC), Polyvinylbutyral, Polyethylenglykol, Polymethylmethacrylat, Dextran, Azobis und Dodecylbenzolsulfat-Natrium.

7. Fotosinterbare Nano-Tinte nach Anspruch 3, wobei der Klebstoff mindestens eines der folgenden umfasst: Urethanharz, Acrylharz, Epoxidharz, Epoxidsilan und Styrolharz.

8. Foto-Sinterverfahren, umfassend:
Herstellen einer fotosinterbaren Nano-Tinte (200) gemäß einem der Ansprüche 3 bis 7;
einen Fotosinter-Tinten-Beschichtungsschritt des Beschichtens eines flexiblen Substrats (300) mit der fotosinterbaren Nano-Tinte (200); und
einen Fotosinter-Schritt des Fotosinterns der auf das flexible Substrat aufgebrachten fotosinterbaren Nano-Tinte unter Verwendung von weißem Licht.

9. Foto-Sinterverfahren nach Anspruch 8, wobei in dem Fotosinter-Schritt eine Temperatur, auf die die auf das flexible Substrat (300) aufgebrachte fotosinterbare Nano-Tinte (200) durch das weiße Licht erwärmt wird, höher ist als eine Temperatur, auf die das flexible Substrat durch das weiße Licht erwärmt wird.

10. Foto-Sinterverfahren nach Anspruch 8, wobei das Herstellen der fotosinterbaren Nano-Tinte (200) umfasst:
Mischen des Fotosinter-Vorläufers mit einer Basislösung, die das Polymerbindemittelharz und den Klebstoff enthält.

## Revendications

1. Nanostructure conductrice (100) comprenant :
une pluralité de nanoparticules conductrices (10) ; et
un film d'oxyde (20) entourant chacune de la pluralité de nanoparticules conductrices (10),
dans laquelle la nanoparticule conductrice (10) est une nanoparticule de cuivre, et le film d'oxyde (20) est constitué de Cu₂O,
dans laquelle le film d'oxyde est formé par de l'oxygène fourni sur la nanoparticule conductrice (10) à une concentration de 8 000 ppm ou plus, et inférieure à 17 000 ppm, et
dans laquelle un rapport d'une épaisseur du film d'oxyde (20) à une longueur radiale de la nanoparticule conductrice (10) est de 0,1 % ou plus et de 8 % ou moins.

2. Nanostructure conductrice selon la revendication 1, dans laquelle le film d'oxyde (20) a une épaisseur de 0,1 nm ou plus et de 7,8 nm ou moins.

3. Nano-encre de photo-frittage (200) comprenant :
un précurseur de photo-frittage comprenant la nanostructure conductrice (100) selon l'une des revendications 1 et 2 ;
une résine de liant polymère ; et
un adhésif.

4. Nano-encre de photo-frittage selon la revendication 3, dans laquelle la résine de liant polymère est de 0,5 % en poids à 5 % en poids sur la base d'un poids total de la nano-encre de photo-frittage (200).

5. Nano-encre de photo-frittage selon la revendication 3, dans laquelle la résine de liant polymère a un poids moléculaire moyen en poids de 10 000 à 500 000.

6. Nano-encre de photo-frittage selon la revendication 3, dans laquelle la résine de liant polymère comprend au moins l'un parmi la polyvinylpyrrolidone (PVP), l'alcool polyvinylique (PVA), l'éthylcellulose (EC), le polyvinylbutyral, le polyéthylène glycol, le polyméthacrylate de méthyle, le dextrane, l'azobis, et le dodécylbenzène sulfate de sodium.

7. Nano-encre de photo-frittage selon la revendication 3, dans laquelle l'adhésif comprend au moins l'un parmi une résine d'uréthane, une résine acrylique, une résine époxy, un époxy silane, et une résine de styrène.

8. Procédé de photo-frittage comprenant :
la préparation d'une nano-encre de photo-frittage (200) selon l'une des revendications 3 à 7 ;
une étape de revêtement d'encre de photo-frittage consistant à revêtir un substrat flexible (300) avec la nano-encre de photo-frittage (200) ; et
une étape de photo-frittage consistant à photo-fritter la nano-encre de photo-frittage revêtue sur le substrat flexible en utilisant une lumière blanche.

9. Procédé de photo-frittage selon la revendication 8, dans lequel, dans l'étape de photo-frittage, une température à laquelle la nano-encre de photo-frittage (200) revêtue sur le substrat flexible (300) est chauffée par la lumière blanche est supérieure à une température à laquelle le substrat flexible est chauffé par la lumière blanche.

10. Procédé de photo-frittage selon la revendication 8, dans lequel la préparation de la nano-encre de photo-frittage (200) comprend
le mélange du précurseur de photo-frittage avec une solution de base comprenant la résine de liant polymère et l'adhésif.
